# EUROPEAN PATENT SPECIFICATION

(11) **EP 1 347 491 B1**
(45) Date of publication and mention of the grant of the patent: **07.03.2007**
(21) Application number: 03009868.5
(22) Date of filing: 28.08.1998
(51) Int. Cl.: H01J 37/32

(54) **Apparatus for driving the arc in a cathodic arc coater**
Vorrichtung zur Bogenführung in einem kathodischen Bogen-Beschichtungsgerät
Dispositif de conduite de l'arc dans un appareil de revêtement à arc cathodique

(30) Priority: 30.08.1997 US 919132; 30.08.1997 US 919133
(43) Date of publication of application: 24.09.2003
(62) Divisional of application: 98306954.3
(73) Proprietor: UNITED TECHNOLOGIES CORPORATION, Hartford, Connecticut 06101 (US)
(72) Inventor: Beers, Russell A., Palm Beach Gardens, Florida 33418 (US); Royal, Tyrus E., Wethersfield, CT 06109 (US); Ramalingam, Subbiah, St. Paul, Minnesota 55113 (US)
(74) Representative: Hall, Matthew Benjamin

(56) References cited:
- EP-A- 0 508 612
- US-A- 4 492 845
- US-A- 4 673 477
- PATENT ABSTRACTS OF JAPAN vol. 013, no. 105 (C-575), 13 March 1989 (1989-03-13) & JP 63 277758 A (MATSUSHITA ELECTRIC IND CO LTD), 15 November 1988 (1988-11-15)

## Description

This invention relates to cathodic arc vapor deposition.

Vapor deposition as a means for applying a coating to a substrate is a known art that includes processes such as chemical vapor deposition, physical vapor deposition, and cathodic arc vapor deposition. Chemical vapor deposition involves introducing reactive gaseous elements into a deposition chamber containing one or more substrates to be coated. Physical vapor deposition involves providing a source material and a substrate to be coated in a evacuated deposition chamber. The source material is converted into vapor by an energy input, such as heating by resistive, inductive, or electron beam means.

Cathodic arc vapor deposition involves a source material and a substrate to be coated placed in an evacuated deposition chamber. The chamber contains only a relatively small amount of gas. The negative lead of a direct current (DC) power supply is attached to the source material (hereinafter referred to as the "cathode") and the positive lead is attached to an anodic member. An arc-initiating trigger, at or near the same electrical potential as the anode, contacts the cathode and subsequently moves away from the cathode. When the trigger is still in close proximity to the cathode, the difference in electrical potential between the trigger and the cathode causes an arc of electricity to extend therebetween. As the trigger moves further away, the arc jumps between the cathode and the anodic chamber. The exact point, or points, where an arc touches the surface of the cathode is referred to as a cathode spot. Absent a steering mechanism, a cathode spot will move randomly about the surface of the cathode.

The energy deposited by the arc at a cathode spot is intense; on the order of 10⁵ to 10⁷ amperes per square centimeter with a duration of a few to several microseconds. The intensity of the energy raises the local temperature of the cathode spot to approximately equal that of the boiling point of the cathode material (at the evacuated chamber pressure). As a result, cathode material at the cathode spot vaporizes into a plasma containing atoms, molecules, ions, electrons, and particles. Positively charged ions liberated from the cathode are attracted toward any object within the deposition chamber having a negative electrical potential relative to the positively charged ion. Some deposition processes maintain the substrate to be coated at the same electrical potential as the anode. Other processes use a biasing source to lower the potential of the substrate and thereby make the substrate relatively more attractive to the positively charged ions. In either case, the substrate becomes coated with the vaporized material liberated from the cathode.

The random movement of the arc can sometimes lead to non-uniform erosion of the cathode, which in turn can limit the useful life of the cathode. To avoid non-uniform erosion, it is known to steer the arc relative to the cathode. United States Patents Nos. 4,673,477, 4,849,088, and 5,037,522 are examples of patents that disclose apparatus for steering an arc relative to a cathode. Some prior art steers the arc by mechanically manipulating a magnetic field source relative to the cathode. Other prior art steers the arc by alternately electrically connecting a power supply lead between two ends of a cathode. In both these approaches, the speed of the arc relative to the cathode is limited by the speed of the apparatus manipulating the magnetic field source, or switching the power supply. Another limitation is the complexity of the switching mechanisms and the hardware neccesary to manipulate a magnetic field source relative to the cathode. A person of skill in the art will recognize that a production coating environment is harsh and simplicity generally equates with reliability.

Presently available cathodic arc coaters typically use a cooled cathode fixed in place within the coater. One cooling scheme provides a manifold attached to the cathode that permits the passage of coolant between the cathode and manifold. Another scheme uses coolant piping connected to a hollow cathode. A problem with either scheme is that the cathode must be machined to accept the manifold or piping. Not all cathode materials are amenable to machining and even where possible, machining adds significantly to the cost of the consumable cathode. Another problem with "directly cooling" the cathode is the labor required to replace the cathode when its useful life has expired. In the previous example where a manifold (or piping) is mechanically attached to the cathode, the manifold (or piping) must be detached from the old cathode and attached to a new one, and the deposition chamber subsequently cleaned of coolant. For those applications which require cathode replacement after each coating run, the labor costs and down time can be considerable. Still another problem with direct cathode cooling is leakage. Coolant leakage occurring during deposition can contaminate the substrates being coated and require extensive cleaning within the deposition chamber. Airfoils for gas turbine engines are an example of an expensive substrate to be coated; one where it would be a distinct advantage to minimize or eliminate losses due to contamination.

In short, what is needed is an apparatus for cathodic arc vapor deposition of material on a substrate that operates efficiently, one capable of consistently providing a high quality coating on a substrate, one that optimizes cathode erosion, and one that operates cost effectively.

EP-A-0508612 discloses a cathodic arc coater having a cylindrical cathode, the circumferential surface of which is the evaporative surface.

The present invention is an apparatus for applying material by cathodic arc vapor deposition to a substrate as defined in claim 1.

According to a preferred embodiment said magnetic field generator includes a plurality of side magnets attached to said ferromagnetic center piece, and a center magnet positioned radially inside of said side magnets; wherein each said side magnet produces a magnetic field that permeates said cathode, each said magnetic field including a portion that runs substantially parallel to said evaporative surface; and wherein said center magnet influences said arc path relative to said axially extending evaporative surface; and wherein said arc of electrical energy extending between said cathode and said anode liberates a portion of said cathode which is subsequently deposited on the substrate located inside said vessel.

An advantage of the present invention is that the apparatus for cathodic arc vapor deposition of material on a substrate is designed to operate in a cost effective manner. One cost effective characteristic of the present invention is the cathode, which is disk-shaped and so may be cut, for example, from a cylindrical casting. The simply formed cathode requires minimal expensive machining, thereby reducing the cost of the cathode and the overall coating process. Another cost effective characteristic is that the erosion of the cathode is circumferentially uniform. As a result, the life of the cathode can be maximised before replacement is necessary.

Another advantage of the present invention is uniformity of the coating process. The means for steering the arc around the cathode increases the uniformity of the cathode erosion. Specifically, steering the arc around the circumference of the cathode at a substantially constant velocity causes uniform circumferential erosion of cathode. The substrates disposed around and equally spaced from the cathode consequently receive a more uniform deposition of coating. In addition, the velocity of the arc around the cathode circumference is a function of the strength of the magnetic field and the amount of current supplied. As a result, the velocity of the arc can be manipulated by changing the amount of current, the strength of the magnetic field, or both.

Another advantage of the present invention is the simplicity and reliability of the means for steering the arc around the cathode. The means for steering the arc includes a magnetic field generator having a ferromagnetic centerpiece and preferably a plurality of side magnets; no switching mechanism is required. The absence of a switching mechanism increases the reliability of the steering means.

Preferably, a protective coating encasing the ferromagnetic center piece and the magnets is provided to inhibit corrosion of the ferromagnetic center piece and the magnets.

Certain preferred embodiments will now be described by way of example only and with reference to the accompanying drawings, in which:
FIG.1 is a diagrammatic view of a preferred cathodic arc vapor deposition apparatus ;
FIG.2 is a diagrammatic cross-sectional view of a contactor, showing twin magnetic field generators;
FIG.3 is a diagrammatic side view of a magnetic field generator;
FIG.4 is a top view of the magnetic field generator shown in FIG. 3 ;
FIG.5 is a diagrammatic top view of a magnetic field generator having annular side magnets;
FIG.6 is a side view of the magnetic field generator shown in FIG.5;
FIG.7 is a diagrammatic view of a cathode and magnetic field generator with a center magnet, including magnetic field lines permeating the cathode; and
FIG.8 is a diagrammatic view of a cathode and magnetic field generator, including magnetic field lines permeating the cathode.

### I. Apparatus

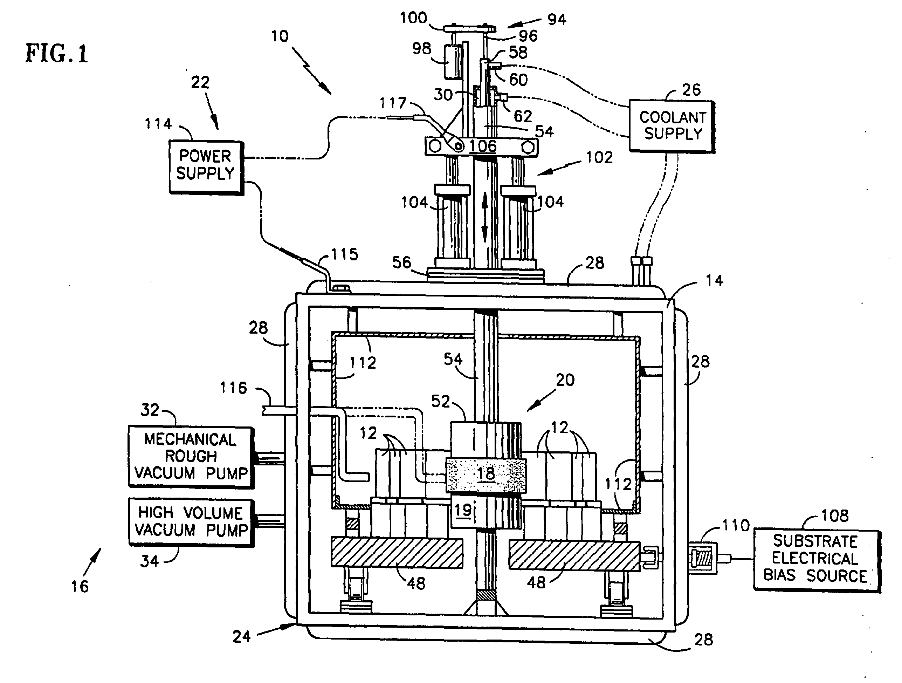

Referring to FIG.1, an apparatus 10 for cathodic arc vapor deposition on a substrate 12, hereinafter referred to as a "cathodic arc coater", is provided having a vessel 14, means 16 for maintaining a vacuum in the vessel 14, a cathode 18, a contactor 20, and means 22 for sustaining an arc of electrical energy between the cathode 18 and an anode 24. A coolant supply 26 maintains the apparatus 10 within acceptable temperatures by cycling coolant through cooling passages 28,30 within the vessel 14 and contactor 20. In the preferred embodiment, the means 16 for maintaining a vacuum in the vessel 14 includes a mechanical rough vacuum pump 32 and a high volume diffusion-type vacuum pump 34 piped to the interior of the vessel 24. Other vacuum means may be used alternatively.

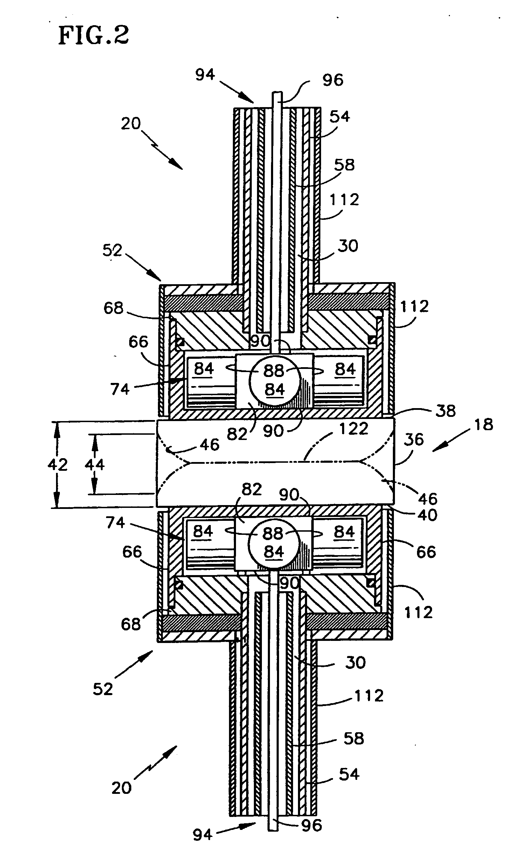

Referring to FIGS. 1 and 2, the cathode 18 is a substantially cylindrical disk having an evaporative surface 36 extending between a pair of end surfaces 38,40. The end surfaces 38,40 are substantially parallel with one another. The coating to be deposited dictates the material composition of the cathode 18, and often the cathode 18 can simply be cut from a cast rod. The axial length 42 of the cathode 18 is preferably longer than the anticipated final width 44 of the erosion pattern 46 along the evaporative surface 36 of the cathode 18. Keeping the erosion pattern 46 between the end surfaces 38,40 minimizes the possibility that the arc will leave the evaporative surface 36 of the cathode 18. The substrates 12 are mounted on a platter 48 that rolls into and out of the vessel 14. The platter 48 includes means for rotating the substrates (not shown).

The contactor 20 includes a head 52 attached to a shaft 54. The head 52 is positioned inside the vessel 14 and the shaft 54 extends from the head 52 to outside the vessel 14. An insulative disk 56 electrically insulates the contactor 20 from the vessel 14. The contactor 20 preferably further includes a cooling tube 58 coaxially positioned within the shaft 54, a coolant inlet port 60 (see FIG.1) connected to the cooling tube 58, and a coolant exit port 62 connected to the passage 30 formed between the coaxial coolant tube 58 and shaft 54. The coaxial arrangement between the cooling tube 58 and the shaft 54 allows coolant from the coolant supply 26 to enter the cooling tube 58 and return via the passage 30 between the shaft 54 and the cooling tube 58, or vice versa.

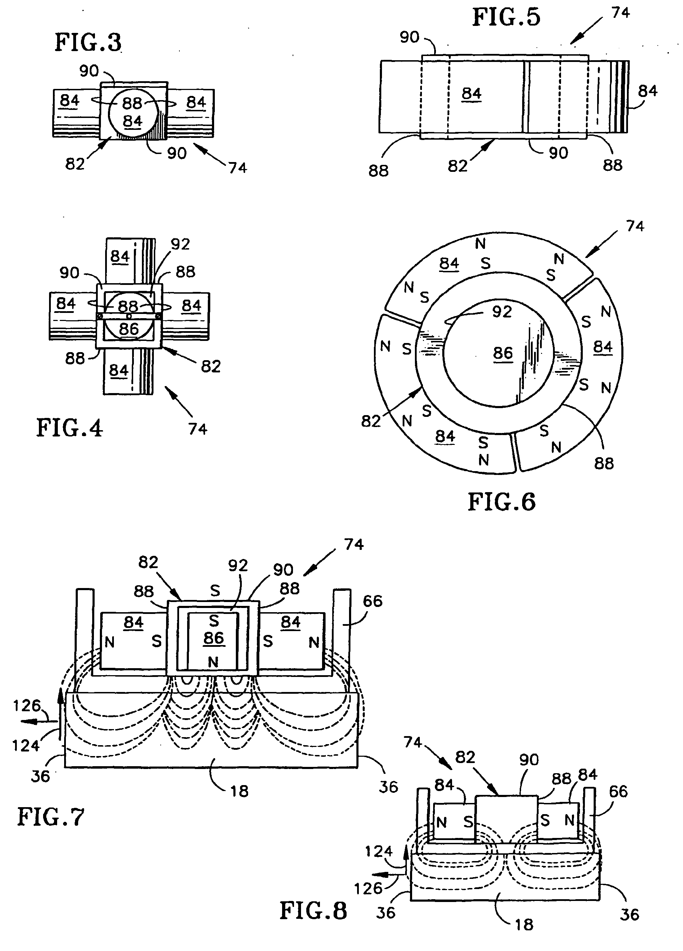

Referring to FIGS. 2-8, the contactor head 52 includes a cup 66, a shaft flange 68, and a magnetic field generator 74. The shaft flange 68 is fixed to the shaft 54 and the cup 66 is removably attached to the shaft flange 68. The cup 66, shaft flange 68, and shaft 54 are fabricated from an electrically conductive material such as a copper alloy. The magnetic field generator 74 includes a ferromagnetic center piece 82 arranged on the central axis of the cylindrical cathode 18, a plurality of side magnets 84, and a center magnet 86. The center piece 82 includes at least one side surface 88 extending between two end surfaces 90, and a hollow 92 for receiving the center magnet 86. The side 84 and center 86 magnets are preferably permanent magnets, although alternative magnetic field sources such as electromagnetics may be used. Cylindrical permanent magnets, for example, are advantageous because they are commercially available and relatively inexpensive (see FIGS. 2-4,7, and 8). An annular magnet, segmented or whole, may be used alternatively (see FIGS. 5 and 6). The side magnets 84 are attached to the side surface 88 and the center magnet 86 is either received within the hollow 92 or attached to an end surface 90. FIG.8 shows a magnetic field generator 74 that includes a ferromagnetic center piece 82 and side magnets 84, but does not include a center magnet 86. In all embodiments, the number of side magnets 84 can be varied to accommodate the process at hand.

Referring to FIGS. 1 and 2, apparatus 94 is included for rotating the magnetic field generator. The rotation apparatus 94 includes a rod 96 extending through the coolant tube 58 and into the head 52 where it connects with the ferromagnetic center piece 82. The opposite end of the rod 96 is connected to a variable speed drive motor 98 via a drive belt 100 (see FIG.1).

The cathodic arc coater 10 may also include an actuator 102 for selectively actuating the contactor 20 into electrical contact with the cathode 18 which includes a pair of two-way actuating cylinders 104 (hydraulic or pneumatic) acting between the vessel 14 and a shaft flange 106 attached to the contactor shaft 54. Mechanical apparatus may be used in place of the actuating cylinders 104. A commercially available controller (not shown) can be used to control the position and force of the cylinders 104 (or mechanical apparatus). FIG.1 shows the cathode 18 disposed between a fixed support 19 and an actuable contactor 20. FIG.2 shows an alternative cathode 18 arrangement wherein a contactor 20 is in contact with each end surface 38,40 of the cathode 18. The second contactor 20 may be fixed or actuable.

The cathodic arc coater 10 preferably includes a biasing source 108 for electrically biasing the substrates 12. Negatively biasing the substrates 12 relative to the anode 24 makes the substrates 12 electrically attractive to positive ions liberated from the cathode 18. A contact 110 electrically connects the biasing source 108 to the platter 48. The substrates 12, which are electrically connected to the platter 48, are consequently electrically connected to the biasing source 108. Other means for electrically connecting the substrates 12 to the biasing source 108 may be used alternatively.

Deflector shields 112 are used throughout the coater 10 to confine the vaporized cathode materials in the area of the substrates 12. The deflector shields 112 attached to the vessel 14, platter 48, and contactor 20 also minimize undesirable material build-up on those surfaces. In the preferred embodiment, the deflector shields 112 attached to the vessel 14 are electrically connected to the vessel 14 and are made of an electrically conductive material resistant to corrosion, such as stainless steel.

The means 22 for sustaining an arc of electrical energy between the cathode 18 and an anode 24 includes a direct current (D.C.) power supply 114. In the preferred embodiment, the positive lead 115 of the power supply 114 is connected to the vessel 14, thereby making the vessel 14 act as an anode. The negative lead 117 of the power supply 114 is electrically connected to the contactor shaft 52. Alternative embodiments may use an anode (not shown) disposed inside the vessel 14. An arc initiator 116, maintained at or near the electrical potential of the vessel 14, is used to initiate an arc.

### II. Operation of the Apparatus

Referring to FIG.1, in the operation of the present invention cathodic arc coater 10, a plurality of substrates 12 and a cathode 18 are attached to the platter 48 and loaded into the vessel 14. The substrates 12 have been previously degreased and substantially cleaned, although each will likely have some molecular contaminant and oxidation remaining on its exterior surface. The actuating cylinders 104 subsequently actuate the contactor 20 into electrical contact with the cathode 18 and the vessel 14 is closed.

The mechanical rough vacuum pump 32 is operated to evacuate the vessel 14 to a predetermined pressure. Once that pressure is reached, the high volume diffusion vacuum pump 34 further evacuates the vessel 14 to near vacuum conditions. The substrates 12 are then cleaned of any remaining contaminants and/or oxidation by a method such as "sputter cleaning". Sputter cleaning is a process well known in the art and will not be described in detail here. Other cleaning methods may be used alternatively. After the substrates 12 are cleaned, the contaminants are purged typically using an inert gas.

Prior to initiating an arc several steps are completed, including: (1) the substrates 12 are electrically biased via the biasing source 108, making them electrically attractive to positive ions emitted from the cathode 18; (2) the substrates 12 are rotated at a particular rotational speed; (3) the power supply 114 is set to establish an arc having a particular magnitude of current and voltage, but no arc is initiated; (4) the vacuum pumps 32,34 establish and maintain a particular vacuum pressure of gas within the vessel 14; and (5) coolant is cycled through the cooling passages 28,30 within the vessel 14 and contactor 20. Specific process parameters will depend upon factors such as the substrate material, the material to be coated, and the desired characteristics of the coating, etc.

Once the aforementioned steps have been completed, the arc initiator 116 is brought into and out of contact with the evaporative surface 36 of the cathode 18, causing an arc to jump between the arc initiator 116 and the evaporative surface 36. The arc initiator 116 is subsequently moved a distance away from the cathode 18, preferably radially outside of the substrates 12. Once the arc initiator 116 is no longer proximate the cathode. 18, the arc jumps between the cathode 18 and the deflector shields 112 electrically connected to the vessel 24 (or directly between the cathode 18 and the vessel 24).

The magnetic field generator 74 positioned in the contactor 20 drives the cathode spot along the evaporative surface 36 of the cathode 18. To be more specific, each side magnet 84 produces a magnetic field that permeates the cathode 18 and runs substantially parallel to the cathode evaporative surface 36 in the axial direction. FIGS. 7 and 8 show an approximation of where the magnetic field lines are believed to run and vector 124 represents the magnetic field extending between the cathode end surfaces 38,40. The direction of the magnetic field vector 124 depends upon the orientation of the side magnet 84 poles, and all side magnets 84 are oriented in like manner. A vector 126 representing the electric arc, in contrast, extends away from the evaporative surface 36 in a substantially perpendicular direction. Together, the magnetic field and the electric current of the arc create a force (the Hall effect) on the arc that causes the arc to travel a distance around the circumference of the cathode 18. The dwell time of the arc at any particular cathode spot is inversely related to the Hall effect force; i.e., an increase in the Hall effect force, causes a decrease in the dwell time. A person of skill in the art will recognize that decreasing the dwell time reduces the occurrence of macro-particles which can adversely effect the uniformity and surface finish of the deposited coating.

The individual magnetic fields of the side magnets 84, in close circumferential proximity to one another, collectively force the arc to circle the cathode evaporative surface 36 along an arc path 122 (see FIG.2). The number of side magnets 84, the relative spacing of magnetic fields emanating from side magnets 84, and the intensity of those magnetic fields can be adjusted to satisfy the application at hand. In some applications, however, it is advantageous to further include a center magnet 86. The magnetic field of the center magnet 86 appears to influence the geometry of the magnetic fields emanating from the side magnets 84. As a result, the arc path 122 around the circumference of the cathode 18 is moved axially away from the side magnets 84. Hence, the center magnet 86 can be used to move the axial position of the arc path 122. FIG.7 shows an approximation of how the magnetic field lines from the side magnets 84 and center magnet 86 are believed to interact. An arc path 122 proximate the axial midpoint of the cathode 18 helps maintain the arc away from the contactor 20 (or between both contactors 20), thereby minimizing undesirable wear on the contactor 20. An arc path 122 (and consequent erosion geometry) proximate the axial midpoint also helps increase the efficiency of the coating process by maximizing the amount of material that can be eroded from a particular cathode 18.

The energy delivered by the arc causes the material at the cathode spot to vaporize, thereby liberating atoms, molecules, ions, electrons, and particles from the cathode 18. The biased substrates 12 attract the ions, causing them to accelerate toward the substrates 12. The ions strike the exterior surface of the substrates 12, attach, and collectively form a coating of the cathode material.

FIG.2 shows an eroded cathode 18 in phantom, substantially symmetrical about the arc path 122. In the embodiment, rotation of the magnetic field generator 74 within the contactor 20 helps promote uniform axial and circumferential erosion of the cathode 18. The rotation distributes the magnetic contribution of each side magnet 84 around the circumference of the cathode 18 as a function of time. It must be emphasized, however, that rotation of the magnetic field generator 74 is not required to create a circling arc. As stated above, the individual magnetic fields of the side magnets 84 collectively force the arc to circle the cathode evaporative surface 36.

Referring to FIG.1, when a coating of sufficient thickness has been deposited on the substrates 12, the power supply 114 is turned off and the arc extinguished. The vessel 14 is purged with inert gas and brought to ambient pressure. The contactor 20 is actuated out of contact with the cathode 18 and the platter 48 is removed from the vessel 14. The substrates 12 are subsequently removed from the platter 48 and new substrates 12 attached. The loaded platter 48 is then inserted back into the vessel 14 in the manner described earlier and the process repeated.

It will be understood by those skilled in the art that various changes in form and detail of the above detailed embodiments may be made without departing from the scope of the invention. In one example, means for cooling the contactor 20 may be used other than that disclosed above. In another example, a power supply 114 that simulates direct current, such as one having an LCR circuit or other rectifying means, may be used in place of a D.C. power supply 114. In another example, one or both contactors are actuable. In some cases, however, it may be acceptable to have stationary contactors 20.

Thus, at least according to the illustrated embodiments, there is provided an apparatus for cathodic arc vapor deposition of material on a substrate that operates in a cost effective manner; which provides a uniform high quality coating on every substrate within the apparatus; and which includes apparatus for steering an arc relative to a cathode that overcomes the limitations of the prior art.

## Claims

1. An apparatus for applying material by cathodic arc vapor deposition to a substrate (12), comprising:
a vessel (14);
means (16) for maintaining a vacuum in said vessel (14);
a cylindrical cathode (18) having a central axis, positioned inside said vessel (14), having a first end surface (38), a second end surface (40), and an evaporative surface (36) axially extending therebetween;
means (22) for selectively sustaining an arc of electrical energy between said evaporative surface (36) and an anode (14,24,112); and
means having a magnetic field generator (74) for driving said arc around said evaporative surface positioned in close proximity to said cathode, and said magnetic field generator (74) being arranged to produce a magnetic field that permeates said cathode and which has a portion (124) that runs substantially parallel to said evaporative surface (36) of said cathode (18) in the axial direction such that said arc liberates a portion of said cathode (18) to be subsequently deposited on a substrate (12) located inside said vessel (14);
**characterised in that**:
the cathode is a cylindrical disk; and
said magnetic field generator (74) includes
a ferromagnetic center piece (82) arranged on said central axis.

2. An apparatus according to claim 1, wherein said means (22) for sustaining an arc of electrical energy between said cathode (18) and said anode (14,24,112) comprises:
a power supply (114), having a positive lead (115) and a negative lead (117);
wherein said negative lead of said power supply is electrically connected to said cathode (18), and said positive lead is electrically connected to said vessel (14), thereby making said vessel act as said anode; and
wherein said cathode (18) is electrically insulated from said vessel (14).

3. An apparatus according to claim 1 or 2, wherein said magnetic field generator (74), further comprises:
a plurality of magnets (84), wherein each magnet is attached to a side surface of said ferromagnetic center piece (82) and said magnets are uniformly spaced around said ferromagnetic center piece (82).

4. An apparatus according to claim 3, wherein each said magnet (84) is cylindrically shaped, having a first polar end and a second polar end, said second polar end having a polarity opposite that of said first polar end;
wherein said first polar end of each said magnet (84) is attached to said ferromagnetic centerpiece (82).

5. An apparatus according to claim 1 or 2, wherein said magnetic field generator (74) comprises an annular magnet (84), having an inner radial surface and an outer radial surface, said outer radial surface having a polarity opposite that of said inner radial surface;
wherein said inner radial surface is attached to said ferromagnetic centerpiece (82).

6. An apparatus according to claim 5, wherein a plurality of magnet segments collectively form said annular magnet (84).

7. An apparatus according to any of claims 3 to 6, wherein said magnet or magnets (84) is/are permanent magnets.

8. An apparatus according to any of claims 3 to 7, further comprising:
a protective coating, said coating encasing said ferromagnetic center piece (82) and said magnet or magnets (84) to inhibit corrosion of said ferromagnetic center piece and said magnet or magnets (84).

9. An apparatus according to any preceding claim, further comprising:
a housing (66,68), in contact with one of said cathode end surfaces (38,40);
wherein said magnetic field generator (74) is enclosed within said housing (66,68).

10. An apparatus according to claim 9, further comprising:
means for selectively transferring thermal energy from said housing (66,68);
wherein said means for transferring thermal energy selectively transfers thermal energy from said housing (66,68).

11. An apparatus according to claim 9 or 10, further comprising:
a rotator (96,98,100), attached to said ferromagnetic center piece (82);
wherein said rotator rotates said magnetic field generator (74) including its ferromagnetic center piece (82) inside said housing (66,68).

12. An apparatus according to claim 11, wherein said rotator comprises:
a drive motor (98), positioned outside said vessel (14);
a rod (96), attached to said ferromagnetic center piece (82), wherein said rod extends outside said vessel and is selectively rotated by said drive motor (98).

13. An apparatus according to any preceding claim, wherein said means for driving said arc around said evaporative surface (36) comprises:
a pair of magnetic field generators (74) each attached to a ferromagnetic center piece (82);
wherein one of said magnetic field generators is positioned in close proximity to said first end surface (38), and the other of said magnetic field generators (74) is positioned in close proximity to said second end surface (40);
wherein each said magnetic field generator (74) produces a magnetic field having a portion (124) that runs substantially parallel to said evaporative surface of said cathode (18).

## Patentansprüche

1. Vorrichtung zum Aufbringen von Material durch Kathodenbogen-Dampfabscheidung auf ein Substrat (12), aufweisend:
ein Gefäß (14);
eine Einrichtung (16) zum Aufrechterhalten eines Vakuums in besagtem Gefäß (14);
eine zylindrische Kathode (18) mit einer Zentralachse, welche innerhalb des Gefäßes (14) angeordnet ist, mit einer ersten Endfläche (38), einer zweiten Endfläche (40) und einer Verdampfungsfläche (36), die sich axial zwischen diesen erstreckt;
eine Einrichtung (22) zum selektiven Aufrechterhalten eines Bogens elektrischer Energie zwischen besagter Verdampfungsfläche (36) und einer Anode (14, 24, 112); und
eine Einrichtung zum Treiben des Bogens um die Verdampfungsfläche, mit einem Magnetfeldgenerator (74), welcher in dichter Nähe der Kathode angeordnet ist, wobei der besagte Magnetfeldgenerator (74) derart angeordnet ist, dass er ein Magnetfeld erzeugt, welches in die Kathode eindringt und welches einen Bereich (124) aufweist, der im wesentlichen parallel zur Verdampfungsfläche (36) der Kathode in axialer Richtung verläuft, derart, dass der Bogen einen Teil der Kathode (18) abscheidet, der nachfolgend an einem innerhalb des Gefäßes (14) angeordneten Substrat (12) abgeschieden werden soll;
**dadurch gekennzeichnet, dass**:
die Kathode eine zylindrische Scheibe ist; und
besagter Magnetfeldgenerator (74) ein an der Zentralachse angeordnetes ferromagnetisches Zentralstück (82) aufweist.

2. Vorrichtung gemäß Anspruch 1, wobei die Einrichtung (22) zum Aufrechterhalten eines Bogens elektrischer Energie zwischen der Kathode (18) und der Anode (14, 24, 112) aufweist:
eine Stromversorgung (114) mit einer positiven Zuleitung (115) und einer negativen Zuleitung (117);
wobei die negative Zuleitung der Stromversorgung elektrisch mit der Kathode (18) verbunden ist, und die positive Zuleitung elektrisch mit dem Gefäß (14) verbunden ist, so dass das Gefäß als Anode wirkt; und
wobei die Kathode (18) elektrisch von dem Gefäß (14) isoliert ist.

3. Vorrichtung gemäß Anspruch 1 oder 2, wobei der Magnetfeldgenerator (74) weiterhin aufweist:
eine Mehrzahl von Magneten (84), wobei jeder Magnet an einer Seitenfläche des ferromagnetischen Zentralstücks (82) angebracht ist und die Magneten gleichmäßig beabstandet um das ferromagnetische Zentralstück (82) angeordnet sind.

4. Vorrichtung gemäß Anspruch 3, wobei jeder Magnet (84) eine zylindrische Form hat, mit einem ersten polaren Ende und einem zweiten polaren Ende,
wobei das zweite polare Ende eine dem ersten polaren Ende entgegengesetzte Polarität aufweist;
wobei das erste polare Ende jedes Magneten (84) am ferromagnetischen Zentralstück (82) angebracht ist.

5. Vorrichtung gemäß Anspruch 1 oder 2, wobei der Magnetfeldgenerator (74) einen ringförmigen Magneten (84) mit einer inneren radialen Fläche und einer äußeren radialen Fläche aufweist, von denen die äußere radiale Fläche eine der inneren radialen Fläche entgegen gesetzte Polarität hat;
wobei die innere radiale Fläche am ferromagnetischen Zentralstück (82) angebracht ist.

6. Vorrichtung gemäß Anspruch 5, wobei eine Mehrzahl von Magnetsegmenten zusammen den ringförmigen Magneten (84) bilden.

7. Vorrichtung gemäß einem der Ansprüche 3 bis 6, wobei es sich bei dem/den Magnet/en (84) um Permanentmagneten handelt.

8. Vorrichtung gemäß einem der Ansprüche 3 bis 7, ferner aufweisend:
eine Schutzschicht, wobei diese das ferromagnetische Zentralstück (82) und den/die Magnet/en (84) umgibt, um Korrosion des ferromagnetischen Zentralstücks und des/der Magneten (4) zu verhindern.

9. Vorrichtung gemäß einem der vorangehenden Ansprüche, ferner aufweisend:
ein Gehäuse (66, 68), das in Kontakt mit einer der Kathodenendflächen (38, 40) steht;
wobei der Magnetfeldgenerator in dem Gehäuse (66, 68) eingeschlossen ist.

10. Vorrichtung gemäß Anspruch 9, ferner aufweisend:
eine Einrichtung zum selektiven Übertagen von thermischer Energie von dem Gehäuse (66, 68);
wobei die Einrichtung zum Übertragen von thermischer Energie selektiv thermische Energie von dem Gehäuse (66, 68) überträgt.

11. Vorrichtung gemäß Anspruch 9 oder 10, ferner aufweisend:
einen Rotator (96, 98, 100), der an dem ferromagnetischen Zentralstück (82) angebracht ist;
wobei der Rotator den Magnetfeldgenerator (74) innerhalb des Gehäuses rotiert, einschließlich seines ferromagnetischen Zentralstücks.

12. Vorrichtung gemäß Anspruch 11, wobei der Rotator aufweist:
einen Antriebsmotor (98), der außerhalb des Gefäßes (14) angeordnet ist;
eine Stange (96), die an dem ferromagnetischen Zentralstück (82) angebracht ist, wobei die Stange sich außerhalb des Gefäßes erstreckt und selektiv von dem Antriebsmotor (98) gedreht wird.

13. Vorrichtung gemäß einem der vorangehenden Ansprüche, wobei die Einrichtung zum Treiben des Bogens um die Verdampfungsfläche (36) aufweist:
ein Paar Magnetfeldgeneratoren, von denen jeder an einem ferromagnetischen Zentralstück (82) angebracht ist;
wobei einer der Magnetfeldgeneratoren in dichter Nähe der ersten Endfläche (38) und der andere der Magnetfeldgeneratoren (74) in dichter Nähe der zweiten Endfläche (40) angeordnet sind;
wobei jeder Magnetfeldgenerator (74) ein Magnetfeld mit einem Bereich (124) erzeugt, der im Wesentlichen parallel zu der Verdampfungsfläche der Kathode (18) verläuft.

## Revendications

1. Appareil pour appliquer un matériau par dépôt de vapeur d'arc cathodique sur un substrat (12), comprenant :
une cuve (14) ;
un moyen (16) permettant de maintenir un vide dans ladite cuve (14) ;
une cathode cylindrique (18) ayant un axe central, placé à l'intérieur de ladite cuve (14), ayant une première surface d'extrémité (38), une seconde surface d'extrémité (40), et une surface d'évaporation (36) s'étendant axialement entre les deux ;
un moyen (22) permettant de soutenir sélectivement un arc d'énergie électrique entre ladite surface d'évaporation (36) et une anode (14, 24, 112) ; et
un moyen permettant d'entraîner ledit arc autour de ladite surface d'évaporation ayant un générateur de champ magnétique (74) placé à proximité immédiate de ladite cathode, et ledit générateur de champ magnétique (74) étant agencé pour produire un champ magnétique qui pénètre ladite cathode et qui a une partie (124) qui court de façon sensiblement parallèle à ladite surface d'évaporation (36) de ladite cathode (18) dans la direction axiale de sorte que ledit arc libère une partie de ladite cathode (18) pour être ensuite déposée sur un substrat (12) placé à l'intérieur de ladite cuve (14) ;
**caractérisé en ce que** :
la cathode est un disque cylindrique ; et
ledit générateur de champ magnétique (74) comprend une pièce centrale ferromagnétique (82) placée sur ledit axe central.

2. Appareil selon la revendication 1, dans
lequel ledit moyen (22) pour soutenir un arc d'énergie électrique entre ladite cathode (18) et ladite anode (14, 24, 112) comprend :
une alimentation électrique (114), ayant un fil positif (115) et un fil négatif (117) ;
dans lequel ledit fil négatif de la dite alimentation électrique est connecté électriquement à ladite cathode (18) et ledit fil positif est connecté électriquement à ladite cuve(14), permettant ainsi à ladite cuve d'agir comme ladite anode ; et
dans lequel ladite cathode (18) est isolée électriquement de ladite cuve (14).

3. Appareil selon la revendication 1 ou 2, dans lequel ledit générateur de champ magnétique (74) comprend en outre :
une pluralité d'aimants (84), dans lesquels chaque aimant est fixé à une surface latérale de ladite pièce centrale ferromagnétique (82) et lesdits aimants sont espacés uniformément autour de ladite pièce centrale ferromagnétique (82).

4. Appareil selon la revendication 3, dans lequel chaque aimant (84) est de forme cylindrique, ayant une première extrémité polaire et une seconde extrémité polaire, ladite seconde extrémité polaire ayant une polarité opposée à celle de ladite première extrémité polaire ;
dans lequel ladite première extrémité polaire de chaque aimant (84) est fixée à ladite pièce centrale ferromagnétique (82).

5. Appareil selon la revendication 1 ou 2, dans lequel ledit générateur de champ magnétique (74) comprend un aimant annulaire (84) ayant une surface radiale interne et une surface radiale externe, ladite surface radiale externe ayant une polarité opposée à celle de ladite surface radiale interne ;
dans lequel ladite surface radiale interne est fixée à ladite pièce centrale ferromagnétique (82).

6. Appareil selon la revendication 5, dans lequel une pluralité de segments d'aimant forment collectivement ledit aimant annulaire (84).

7. Appareil selon l'une des revendications 3 à 6, dans lequel ledit aimant ou lesdits aimants (84) est/ sont des aimants permanents.

8. Appareil selon l'une quelconque des revendications 3 à 7 comprenant en outre un revêtement protecteur, ledit revêtement recouvrant ladite pièce centrale ferromagnétique (82) et ledit aimant ou lesdits aimants (84) pour empêcher la corrosion de ladite pièce centrale ferromagnétique et dudit ou desdits aimant(s)(84).

9. Appareil selon l'une quelconque des revendications précédentes, comprenant en outre un boîtier (66, 68) en contact avec l'une des surfaces d'extrémité de la cathode (38, 40), dans lequel ledit générateur de champ magnétique (74) est incorporé dans ledit boîtier (66, 68).

10. Appareil selon la revendication 9, comprenant en outre :
un moyen permettant de transférer sélectivement l'énergie thermique dudit boîtier (66, 68) ;
dans lequel ledit moyen pour transférer l'énergie thermique transfère l'énergie thermique dudit boîtier (66, 68).

11. Appareil selon la revendication 9 ou 10, comprenant en outre :
un rotateur (96, 98, 100) fixé à ladite pièce centrale ferromagnétique (82) ;
dans lequel ledit rotateur fait tourner ledit générateur de champ magnétique (74) comprenant sa pièce centrale ferromagnétique (82) à l'intérieur dudit boîtier (66, 68).

12. Appareil selon la revendication 11, dans lequel ledit rotateur comprend :
un moteur d'entraînement (98) placé à l'extérieur de ladite cuve (14) ;
une tige (96) fixée à ladite pièce centrale ferromagnétique (82),
dans lequel ladite tige s'étend en dehors de ladite cuve et est pivotée sélectivement par ledit moteur d'entraînement (98).

13. Appareil selon l'une quelconque des revendications précédentes, dans lequel ledit moyen pour entraîner ledit arc autour de ladite surface d'évaporation (36) comprend :
une paire de générateurs de champ magnétique (74) fixés chacun à une pièce centrale ferromagnétique (82) ;
dans lequel un desdits générateurs de champ magnétique est placé à proximité immédiate de ladite première surface d'extrémité (38), et l'autre desdits générateurs de champ magnétique (74) est placé à proximité immédiate de ladite seconde surface d'extrémité (40) ;
dans lequel chacun desdits générateurs de champ magnétique (74) produit un champ magnétique ayant une partie (124) qui court de façon sensiblement parallèle à ladite surface d'évaporation de ladite cathode (18).
